# EUROPEAN PATENT SPECIFICATION

(11) **EP 0 434 904 B1**
(45) Date of publication and mention of the grant of the patent: **08.11.1995**
(21) Application number: 90116851.8
(22) Date of filing: 03.09.1990
(51) Int. Cl.: G11C 8/00, G11C 29/00

(54) **Signal margin testing system**
Signalspielraumprüfsystem
Système de test de marge de signal

(30) Priority: 28.12.1989 US 469885
(43) Date of publication of application: 03.07.1991
(73) Proprietor: International Business Machines Corporation, Armonk, N.Y. 10504 (US)
(72) Inventor: Butler, Edward, Jonesville, Vermont 05466 (US); Ellis, Wayne Frederick, Jericho, Vermont 05465 (US); Redman, Theodore Milton, Milton, Vermont 05468 (US); Thoma, Endre Philip, Colchester, Vermont 05446 (US)
(74) Representative: Jost, Ottokarl, Dipl.-Ing.

(56) References cited:
- EP-A- 0 080 935
- EP-A- 0 212 946
- WO-A-82/00896
- DE-A- 3 232 215
- RESEARCH DISCLOSURE no. 277, May 1987, KENNETH MASON PUBLICATIONS LTD, U.K. page 27718; UNKNOWN: 'CMOS Memory Sorted for Yield Versus Reliability'

## Description

This invention relates to signal margin testing systems for semiconductor integrated circuits and, more particularly, to systems for testing signal margins in high performance semiconductor memory circuits, and preferably in large scale dynamic random access memory systems, at chip, wafer or module levels.

### Background

Testing semiconductor integrated circuits is well known, including the use of test modes for module level testing of dynamic random access memories providing memory chips and circuits with a plurality of test mode options to insure product reliability.

In U.S. Patent 4,468,759, filed on May 3, 1982, by R.I. Kung et al, there is disclosed a testing system or method for dynamic random access memories wherein a higher stored reference voltage in the dummy cells is used when reading binary ones from the memory and a lower dummy reference is used when reading binary zeroes to predict the memory's performance under stressful environmental conditions before packaging the memory chip.

U.S. Patent 4,751,679, filed on December 22, 1986, by S. Dehganpour, discloses a test mode in a dynamic random access memory wherein gates of all transfer devices of the memory cell are subjected to a voltage stress test to provide an accelerated test of the integrity of the gate insulator.

In an article entitled "CMOS Memory Sorted for Yield Versus Reliability" by K.S. Gray et al, in Research Disclosure, May 1987, Number 277, page 27718, published by Kenneth Mason Publications Ltd, England, there is disclosed a system for sorting semiconductor memory chips for high reliability applications by testing for an acceptable output signal from chips without the use of bootstrapped word lines and for high yield of chips for use in applications not requiring the higher reliability with the use of bootstrapped word lines. Word line bootstrapping is enabled on chips by blowing a fuse or changing a D.C. voltage level on a pad.

### Disclosure of the Invention

It is an object of this invention to provide a simple and effective system for signal margin testing in an integrated semiconductor memory by changing the amount of signal on a bit line by a known amount which is a function of process parameters such as the threshold voltage of cell transfer devices and their lengths and widths, temperature, voltage and the technology used in designing the memory circuits to determine reliability, i.e., the projected length of life of the memory.

In accordance with the teachings of this invention as specified in claim 1, a signal margin testing system is provided for a memory having a word line voltage boosting circuit by using a test mode decode circuit to selectively disable the word line boosting circuit and then reading out data from storage cells in the memory.

The foregoing objects, features and advantages of the invention will be apparent from the following more particular description of the preferred embodiments of the invention, as illustrated in the accompanying drawings.

### Brief Description of the Drawings

- Fig. 1: is a circuit diagram, partly in block form, of a dynamic random access memory and signal margin testing system of the present invention, and
- Fig. 2: is a pulse program used in connection with the description of the operation of the memory and test system shown in Fig. 1 of the drawings.

### Best Mode for Carrying Out the Invention

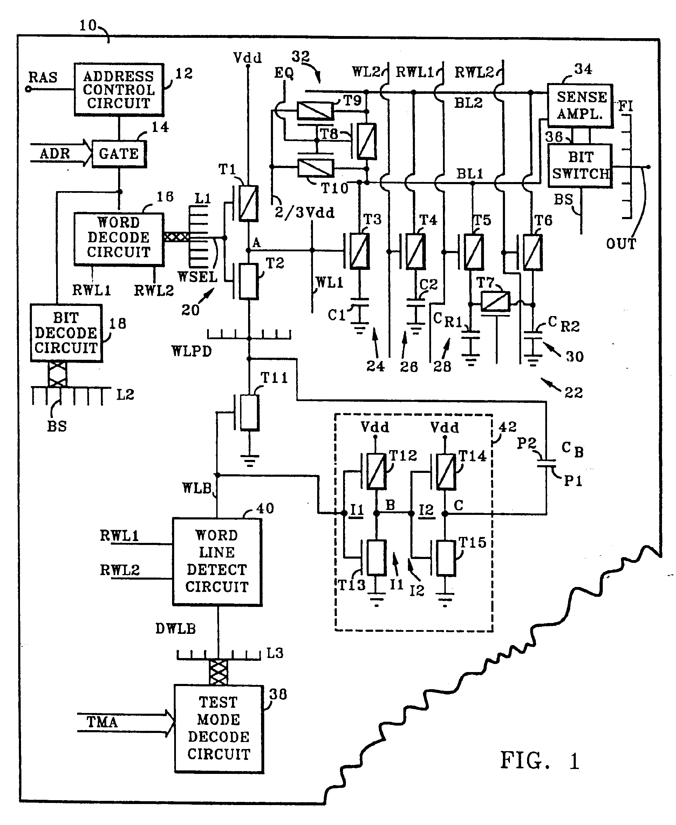

Referring to Fig. 1 of the drawings in more detail, there is shown a circuit diagram, partly in block form, of a preferred embodiment of the signal margin testing system of the present invention. The circuit of the preferred embodiment of the test system of the present invention is made in complementary metal oxide semiconductor (CMOS) technology with P-channel field effect transistors indicated in the drawings by a rectangle with a diagonal line formed therein and a control or gate electrode arranged adjacent thereto and with N-channel field effect transistors indicated by a rectangle without a diagonal line and a control or gate electrode arranged adjacent thereto. The system of the present invention illustrated in Fig. 1 of the drawings includes a semiconductor chip or substrate 10, which may be made of silicon, packaged in module form, having pads or pins Vdd for applying an external supply voltage, RAS for row, or word line, address strobe pulses, ADR for word line and bit line addresses and OUT for output data signals.

An address control circuit 12 has an input connected to the RAS pad and a gate 14 has a first input connected to the output of the address control circuit 12 and additional inputs connected to the address ADR pads. A word decode circuit 16 has an input connected to the output of the gate 14 and a first plurality of output lines L1, one of which is identified as a selected line WSEL, and a second plurality of output lines identified as a first reference word line RWL1 and a second reference word line RWL2. Also connected to the output of the gate 14 is a bit decode circuit 18 having a plurality of output lines L2, one of which is identified as a bit switch line BS. The output line WSEL from the word line decode circuit 16 is connected to a first word line driver 20 having a P-channel field effect transistor T1 serially connected with an N-channel field effect transistor T2 with the source of the transistor T1 being connected to the Vdd pad, to which is applied preferably a voltage of 3.6 volts, the common point between the transistors being an output identified as node A and a control electrode of each of the transistors T1 and T2 being connected to the selected line WSEL.

An array of memory cells 22 is indicated by a first cell 24 and and a second cell 26. The cell 24 includes a transfer device shown as a P-channel field effect transistor T3 having a first current carrying electrode connected to a first bit line BL1 and a second current carrying electrode connected to one side of a storage capacitor C₁, with the other side of the capacitor C₁ being connected to a point of reference potential such as ground. A control electrode of the transistor T3 is connected to a first word line WL1 and the output A of the driver 20. The second cell 26 includes a P-channel field effect transistor T4 having a first current carrying electrode connected to a second bit line BL2 and a second current carrying electrode connected to one side of a storage capacitor C₂, with the other side of the capacitor C₂ being connected to ground. A control electrode of the transistor T4 is connected to a second word line WL2 coupled to an output of a second word line driver (not shown).

A first voltage reference cell 28 includes a transfer device shown as P-channel field effect transistor T5 having a first current carrying electrode connected to the first bit line BL1 and a second current carrying electrode connected to one side of a dummy cell or reference voltage capacitor C_{R1}, with the other side of the capacitor C_{R1} being connected to ground. A control electrode of the transistor T5 is coupled to the reference word line RWL1, which originated at the word decode circuit 16. A second voltage reference cell 30 includes a P-channel field effect transistor T6 having a first current carrying electrode connected to the second bit line BL2 and a second current carrying electrode connected to one side of a dummy cell or reference voltage capacitor C_{R2}, with the other side of the capacitor C_{R2} being connected to ground. A control electrode of the transistor T6 is coupled to the reference word line RWL2. As indicated hereinabove, the reference word lines RWL1 and RWL2 originate at the word decode circuit 16 but, as is known, driver circuits (not shown) are generally used before a voltage from RWL1 or RWL2 is applied to the control electrodes of either transistors T5 or T6. A first equalizing transistor of the P-channel field effect type T7 is connected between the one side of the capacitors C_{R1} and C_{R2}, with a control electrode of the transistor T7 being connected to an equalizing line EQ. An equalizing and bit line voltage charging circuit 32 includes a second equalizing transistor T8 of the P-channel field effect type connected between the first and second bit lines BL1 and BL2 and first and second bit line charging transistors T9 and T10 of the P-channel field effect type, the transistor T9 being connected between the second bit line BL2 and a source of fixed potential, such as 2/3 of Vdd, which may be provided by any suitable on-chip voltage generator, and the transistor T10 being connected between the first bit line BL1 and the fixed potential source.

A sense amplifier circuit 34 has first and second inputs connected to the first and second bit lines BL1 and BL2, respectively. A bit switch circuit 36 has first and second inputs connected to first and second outputs, respectively, of the sense amplifier circuit 34 and an output coupled through a fan-in circuit FI to a data output terminal, pad or pin, OUT. Although not shown, it should be understood that the output of the bit switch circuit 36 is generally coupled to terminal OUT through, e.g., a final amplifier stage and an output driver stage.

Test mode address signals TMA received from the address ADR pads are applied to a test mode address decode circuit 38. Generally the test mode address signals TMA are applied to a plurality of pads or pins ADR, the number of pads or pins depending upon the number of test modes associated with a particular memory or chip. For example, if the memory is designed to be tested by four test modes, then only two of the pads or pins ADR would be required since two decode circuit inputs, each containing binary information, is all that is required for a decode circuit to select any one of the four test modes. The output of the test mode decode circuit 38 is indicated by a plurality of lines L3 with one of the lines identified as DWLB being connected to a first input of a word line detect circuit 40. The word line detect circuit 40 also has second and third inputs connected to the first and second reference word lines RWL1 and RWL2, respectively. An output WLB from the word line detect circuit 40 is connected to a control electrode of a ground transistor T11 which is of the N-channel field effect type. A first current carrying electrode of the transistor T11 is connected to ground and a second current carrying electrode of the transistor T11 is connected to a fan-out identified as a word line pull down WLPD with one line being connected to the source electrode of the transistor T2 of the first word line driver 20.

The output WLB of the word line detect circuit 40 is also connected to an input of a buffer circuit 42 which includes first and second inverters I1 and I2. The first inverter I1 includes a P-channel field effect transistor T12 serially connected with an N-channel field effect transistor T13 with the source of the transistor T12 being connected to the supply voltage source Vdd and the source of the transistor T13 being connected to ground. A control electrode of each of the transistors T12 and T13 is connected to the output WLB of the word line detect circuit 40. The output of the inverter I1 is indicated at node B. The second inverter I2 includes a P-channel field effect transistor T14 serially connected with an N-channel field effect transistor T15 with the source of the transistor 14 being connected to the supply voltage source Vdd and the source of the transistor T15 being connected to ground. A control electrode of each of the transistors T14 and T15 is connected to the output node B of the first inverter I1. The output of the second inverter I2 is indicated at node C. A boost capacitor C_{B} has a first plate P1 connected to the output node C of the buffer circuit 42 and a second plate P2 connected to the fan-out WLPD and the second current carrying electrode or drain of the ground transistor T11.

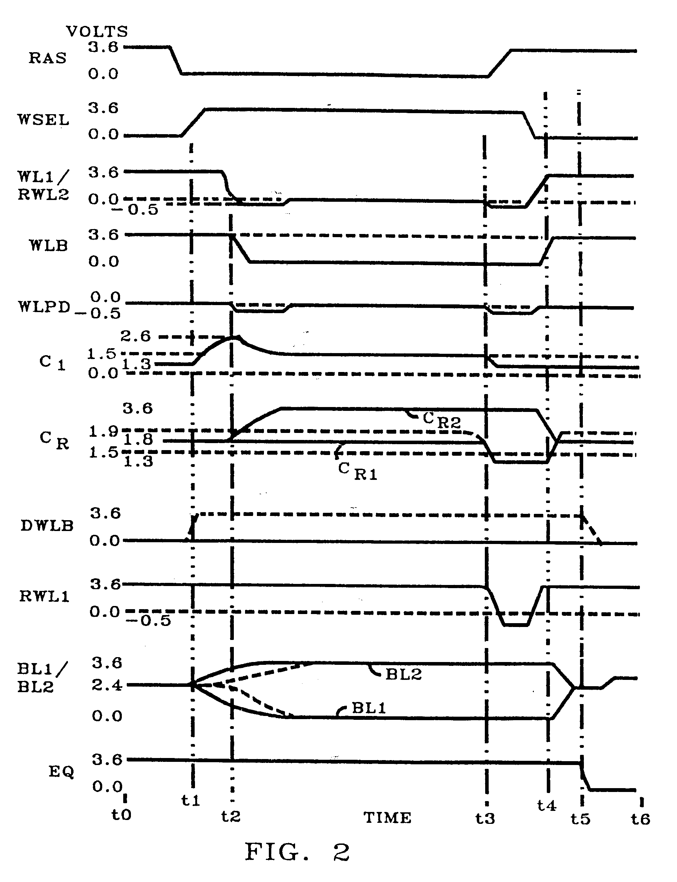

For a better understanding of the operation of the signal margin testing system of the present invention reference may be had to the pulse diagram or program shown in Fig. 2 of the drawings, as well as to the circuit diagram shown in Fig. 1. First consider the normal operation of the dynamic random access memory indicated by the array 22 in Fig.1 of the drawings when the voltage on the word lines WL1 or WL2, and on the reference word lines RWL1 or RWL2, is boosted or driven to a voltage below ground, such as to - 0.5 volts, to provide strong signals at the input of the sense amplifier 34 and improved performance of the memory.

Referring to the solid lines in the graphs of Fig. 2 of the drawings, it can be seen that at time t0 the voltage is high, e.g., at 3.6 volts, at RAS, WL1, RWL1, RWL2, and at EQ, and the voltage is low, e.g., at ground, at WSEL, WLPD and DWLB. Also at time t0, the voltage on the storage capacitor C₁ is at about 1.3 volts, on each of the reference voltage capacitors C_{R1} and C_{R2} is about 1.8 volts and on each of the bit lines BL1 and BL2 is at about 2.4 volts.

As is known, to begin an active cycle for either reading or writing a memory cell, or for both reading and writing, a row address strobe pulse RAS is turned on. In this instance, at time t1 RAS falls to 0 volts to begin an active cycle causing the address control circuit 12 to turn on the gate 14. With the gate 14 turned on, the row or word addresses pass to the word decode circuit 16 which selects one of the lines L1, in this instance the word select line being WSEL wherein the voltage rises to 3.6 volts. At this time the word decode circuit 16 also selects one of the reference word lines RWL1 or RWL2, in this instance line RWL2 being selected. Shortly after time t1, column or bit addresses pass through the gate 14 to the bit decode circuit 18 which selects one line of the plurality of lines L2, in this instance line BS being selected.

With the voltage on the word select line WSEL high, transistor T2 of the word driver 20 turns on to discharge the first word line WL1 causing the transistor T3 of the first cell 24 to turn on. Meanwhile, the voltage on reference word line RWL2, which is also coupled to a driver (not shown) similar to that of the word line driver 20, also begins to discharge. At time t2, after line RWL2 discharges to approximately 1 volt, the word line detect circuit 40 causes the voltage on the word line boost WLB to go to 0 volts turning off the ground transistor T11, and turning on the transistor T12 and turning off the transistor T13 of the first inverter of the buffer circuit 42, which then turns on the transistor T15 and turns off the transistor T14 of the second inverter I2. With the transistor T15 being turned on, the voltage on the plate P1 of the boost capacitor C_{B}, previously charged through the transistor T14, begins to fall toward ground causing the voltage on the second plate P2, previously at ground as indicated by the voltage at the word line pull down WLPD due to the transistor T11 being on, to fall below ground to a voltage of about - 0.5 volts as indicated by the graph at WLPD in Fig. 2.

With the voltage at the word line pull down WLPD at - 0.5 volts and the word line WSEL at 3.6 volts, the transistor T2 is turned on hard to bring the first word line WL1 also to - 0.5 volts. The first word line WL1 being at - 0.5 volts and the first bit line BL1 being at 2.4 volts, the transfer transistor T3 is turned on hard to rapidly transfer cell charge to the first bit line BL1, as indicated in the graph of Fig. 2 at time t2. The rapid rise in voltage on the storage capacitor C₁ is indicated in the graph of Fig. 2 between approximately times t1 and t2. It should be noted that while the transistor T3 is being turned on by the voltage on the first word line WL1, the transistor T6 of the second voltage reference cell 30 is being turned on by the voltage on the second reference word line RWL2. However, since the reference voltage on the reference capacitor C_{R2} is initially higher than the voltage on the first storage capacitor C₁, voltage on the reference capacitor C_{R2} continues to rise until it reaches approximately 3.6 volts due to amplification of the bit line signal in the sense amplifier 34 to which the bit lines BL1 and BL2 are connected. After time t2, the sense amplifier 34 is turned on by known means to read out the information stored in the storage cell C₁ of the first storage capacitor. The voltage on the first bit line BL1 continues to decrease until it reaches 0 volts and the voltage of the second bit line BL2 continues to increase until it reaches the supply voltage source value of 3.6 volts. This information is passed on to the output terminal OUT through the bit switch circuit 36 which is turned on by the voltage on line BS from the bit decode circuit 18. It should be noted that this read out is very reliable and is performed very rapidly due to the boosting action provided by the boost capacitor C_{B}.

After the storage cell has been read out and while the bit lines BL1 and BL2 continue to hold the previously stored information, the storage capacitor C₁ is rewritten with the original information. To rewrite the information, at time t3 the voltage on the reference capacitor C_{R1} and the storage capacitor C₁ is decreased to 1.3 volts by a second boosting of WLPD below ground by operation of the word decode circuit 16 with the first reference word line RWL1 being turned on and connected (not shown) to the fan-out WLPD. The voltage on the line WSEL remains high and the voltage on the line WLB remains low until after the information on the bit lines BL1 and BL2 has been rewritten into the first cell 24. After the information has been rewritten, the voltages on WL1, RWL1 and RWL2 return to their high values at time t4. The reference voltages on the reference capacitors C_{R1} and C_{R2} are equalized by turning on the equalizing transistor T7 at time t5 with a pulse EQ. The pulse EQ may be generated when both reference word line pulses RWL1 and RWL2, and word line boost WLB, go to a high value at time t4 by connecting the word line boost WLB to equalizing circuit (not shown). Also the voltages on the bit lines BL1 and BL2 are similarly equalized by turning on the equalizing transistor T8 of the equalizing and voltage charging circuit 32. While equalizing the voltages on the bit lines BL1 and BL2, the bit lines are also charged to a value such as 2/3 the voltage of Vdd by connecting a 2/3 Vdd voltage generator (not shown) to the bit line through the transistors T9 and T10 which are also controlled by the voltage or pulse EQ. At time t6 all lines, pads and terminals are restored to the same values found at time t0.

To perform signal margin testing of the information stored in the storage capacitor C₁ of the first memory cell 24, test mode address signals TMA received from the address ADR pads are applied to the test mode decode circuit 38 so as to select the disable word line boost DWLB of the plurality of lines L3 at time t1 after the RAS voltage drops to 0 volts. Thereafter, the voltage on line DWLB is increased to 3.6 volts so as to render the word line detect circuit 40 non-responsive to voltages on either of the reference word lines RWL1 or RWL2 by any suitable means. Accordingly, as indicated in the graph by a dashed line at WLB between times t1 and t4, the voltage on line WLB will remain high and, therefore, the transistor T11 will remain on continuously to maintain the voltage at the fan-out or the word line pull down WLPD at ground level throughout the entire active cycle. Meanwhile, the word decode circuit has selected the line WSEL which turns on the transistor T2 of the word line driver 20. Since the voltage on the word line pull down WLPD is only at ground potential and not at the boosted voltage of - 0.5 volts, the transistor T2 does not turn on as hard during this signal margin testing cycle of operation as it did during the normal operation with the boosted word line voltage. Accordingly, the voltage on the bit line BL1 does not drop as rapidly, as indicated by the dashed line at BL1 of the graph in Fig. 2 of the drawings, as it did with the boost voltage on the word line WL1. Consequently, the sense amplifier 34 does not cause the voltage on the second bit line BL2 to rise as rapidly as it did during normal boosted operation.

Since the difference in the voltages on the bit lines BL1 and BL2 at time t2 when the sense amplifier 34 is turned on is significantly less than it was during normal boosted operation, as indicated by the dashed lines in Fig. 2 of the drawings, the sense amplifier will detect only signals which are derived from storage capacitors, such as capacitor C₁ of the first memory cell 24, which contain at least a given level of charge at time t2. Accordingly, this signal margin test will identify those cells in the memory which are capable of producing sufficiently strong signals on the bit lines BL1 and BL2 to be sensed by the sense amplifier 34 at time t2 without the use of a boost voltage on the word line WL1. Since such signals are strong enough to be detected during the read operation without the use of a word line boost voltage, this system provides a very valuable measure of signal strength of the memory.

It should be noted that this test can be performed after the chip has been packaged as a module since access to the memory for test purposes is through available address ADR pins located on the module. It should be understood that when the information read out during the test operation is rewritten into the cells, the voltage at the storage cell C₁ is at 1.5 volts as indicated by the dashed line at C₁ of the graph in Fig. 2 of the drawings. It should also be noted that the operation of the system has been described with a "0" binary digit or low voltage stored in the first cell 24, however, it can be seen that the system provides similar advantages when a "1" binary digit or high voltage is stored in the first cell 24. The most significant difference when a high voltage is stored in the first cell 24 is that the first bit line BL1 would be charged rapidly between times t1 and t2 when the boosted voltage is applied to the first word line WL1 and through feedback action in the sense amplifier 34 the voltage on the second bit line BL2 would fall rapidly. During the test operation, similar action takes place but with the bit line voltage values being indicated by the dashed lines in the graphs BL1 and BL2 of Fig. 2 of the drawings. It should be understood that when the information is read from capacitor C₁, the reference cell voltage at the capacitors C_{R1} and C_{R2} has been similarly modified, so as to reduce signal strength on the bit lines.

Although the memory array 22 has been shown with only two cells 24 and 26, it should be understood that each of the bit lines may have connected thereto numerous cells, and that the memory array 22 may contain, if desired, hundreds of bit line pairs and hundreds of word lines. Furthermore, it should be understood that P-channel field effect transistors have been shown for, e.g., the transfer devices T3 through T6, however, if desired, N-channel field effect transistors may be substituted therefor with appropriately known changes in voltage polarities.

Although the test mode address pulses have been used to initiate this test mode, it should be understood that other voltages may be used to disable the word line boost.

It can be seen that a signal margin system has been provided which is simple to implement via a test mode sequence at either module or system level or even at wafer test and due to easy access to the memory has the potential to save test time. Furthermore, it should be understood that this boost disable technique for testing, results in a discrete amount of signal reduction that relates to process, temperature and voltage. This discrete amount of signal reduction provides a valuable parameter to accurately measure the quality of a memory chip. No additional external voltages or pins are required to implement this technique, and there is no added chip noise.

## Claims

1. A signal margin testing system for carrying out a test sequence in a memory system (22) wherein selected memory cells (24, 26) are accessed for reading or writing during an access cycle, each of the memory cells comprising a transfer device (T3, T4) having a control electrode receiving an access signal, a first controlled electrode coupled to an output line, and a second controlled electrode, and storage means (C1, C2) coupled to the second controlled electrode of the transfer device (T3, T4), the system comprises:
boosting means (42, C_{B}) for boosting the access signal at least once during the access cycle, and
detecting means (38) for detecting that the memory system is in a test mode;
characterized by
preventing means (T11) responsive to the detecting means (38) for preventing the boosting means (42, C_{B}) from operating for at least one complete access cycle during the test mode.

2. The signal margin testing system according to claim 1, characterized in that
the memory system (22) comprises a word line (WL1), and
the boosting means (42, C_{B}) comprises a voltage boosting circuit (42) for applying a first voltage of a given magnitude to the word line (WL1).

3. The signal margin testing system according to claim 1 or 2, characterized by further comprising
activation means (40) coupled to the preventing means (T11) responsive to a first signal (RWL1, RWL2) for activating the boosting means (42, C_{B}) and coupled to said detecting means (38), said defecting means being coupled to a second signal (TMA) for activating the detecting means (38) during the test mode.

4. The signal margin testing system according to claim 2 or 3, characterized in that the detecting means (38) is responsive to the second signal (TMA) for rendering the boosting means (42, C_{B}) inoperative during the test mode wherein a second voltage of a magnitude less than the given magnitude is applied to the word line (WL1).

5. The signal margin testing system as set forth in claim 4, characterized in that the magnitude of the second voltage is less than that of the first voltage in a negative sense.

6. The signal margin testing system as set forth in claim 6, characterized in that the first voltage has a magnitude of - 0.5 volts and the second voltage has a magnitude of zero volts.

7. The signal margin testing system according to any one of the above claims, characterized in that the boosting means (42, C_{B}) includes a capacitor (C_{B}).

8. The signal margin testing system according to any one of the above claims 3 to 7, characterized in that the activation means (40) has first (DWLB) and second (RWL1, RWL2) inputs and an output, the output being coupled to the voltage boosting circuit (42) and the first input being connected to an output of the detecting means (38).

9. The signal margin testing system according to any one of the above claims, characterized in that the memory system (22) further includes a reference word line (RWL1).

10. The signal margin testing system according to claim 9, characterized in that the second input of the activation means (40) being connected to the reference word line (RWL1).

11. The signal margin testing system according to any one of the above claims 2 to 10, characterized by further comprising
a driver (20) connected to the word line (WL1), whereby the preventing means (T11) is coupled to the driver (20).

12. The signal margin testing system according to any one of the above claims 3 to 11, characterized in that the first signal (RWL1, RWL2) is derived from the word line (WLl) and the second signal is an address signal (TMA).

13. The signal margin testing system according to any one of the above claims 3 to 12, characterized in that the activation means (40) comprises a word line detect circuit (40).

14. The signal margin testing system according to any one of the above claims 3 to 13, characterized in that the first signal is derived from the reference word line (RWL1, RWL2).

15. The signal margin testing system according to any one of the above claims, characterized by further comprising
a plurality of bit lines (BL1, B12), and
a sense amplifier circuit (34) having inputs connected to the plurality of bit lines (BL1, B12);
wherein each memory cell (24, 26) is connected to one of the plurality of bit lines (BL1, B12).

16. The signal margin testing system according to claims 15, characterized by further comprising
a voltage reference cell (30) connected to the reference word line (RWL2) and to a first one (BL2) of the plurality of bit lines (BL1, B12).

17. The signal margin testing system according to any one of the above claims, characterized by further comprising
pad means for receiving a plurality of addresses,
word decode means (16) having first and second outputs, and
means (12, 14) for applying a first of the plurality of addresses to an input of the word decode means (16).

18. The signal margin testing system according to claim 17, characterized in that
the driver (20) having an input and an output, the input being coupled to the first output of the word decode means (16),
the detecting means (38) receives a second of the plurality of addresses,
the activation means (40) is coupled to the second output of the word decode means (16) and to the output of the detecting means (38),
a word line pull down node (WLPD) is coupled to the output of the driver (20),
the preventing means (T11) having a control electrode disposed between the word line pull down node (WLPD) and a point of reference potential, the control electrode being coupled to the output of the activation means (40),
the capacitor (C_{B}) having first and second plates, the first plate being coupled to the word line pull down node, and
the voltage boosting circuit (42) having an input coupled to the output of the activation means (40) and an output coupled to the second plate of the capacitor (C_{B}).

19. The signal margin testing system according to any one of the above claims, characterized in that the boosting means (42, C_{B}) comprises a buffer circuit (42) including first (I1) and second (I2) inverters, each of the inverters including a P-channel field effect transistor (T12, T14) serially connected with an N-channel field effect transistor (T13, T15).

20. The signal margin testing system according to any one of the above claims, characterized in that the detecting means (38) includes a test mode decode circuit (38) responsive to address signals (TMA).

21. The signal margin testing system according to any one of the above claims, characterized in that the preventing means (T11) is an N-channel field effect transistor.

## Patentansprüche

1. Signalspielraumprüfsystem zur Durchführung einer Testfolge in einem Speichersystem (22), wobei während eines Zugriffszyklus auf ausgewählte Speicherzellen (24, 26) zum Lesen oder Schreiben zugegriffen wird, jede der Speicherzellen eine Übertragungseinheit (T3, T4) umfaßt, die eine ein Zugriffssignal empfangende Steuerelektrode, eine erste, mit einer Ausgangsleitung verbundene gesteuerte Elektrode und eine zweite gesteuerte Elektrode sowie Speichermittel (C1, C2) hat, die mit der zweiten gesteuerten Elektrode der Übertragungseinheit (T3, T4) verbunden sind, und das System folgendes umfaßt:
Verstärkungsmittel (42, C_{B}), um das Zugriffssignal mindestens einmal während des Zugriffszyklus zu verstärken, und
Erkennungsmittel (38), um festzustellen, daß sich das Speichersystem in einem Testmodus befindet;
gekennzeichnet durch
Verhinderungsmittel (T11), das auf das Erkennungsmittel (38) anspricht, um das Verstärkungsmittel (42, C_{B}) mindestens einen ganzen Zugriffszyklus lang während des Testmodus am Betrieb zu hindern.

2. Signalspielraumprüfsystem nach Anspruch 1, dadurch gekennzeichnet, daß
das Speichersystem (22) eine Wortleitung (WL1) umfaßt und
das Verstärkungsmittel (42, C_{B}) eine Spannungsverstärkungsschaltung (42) umfaßt, um eine erste Spannung einer bestimmten Größe an die Wortleitung (WL1) zu legen.

3. Signalspielraumprüfsystem nach Anspruch 1 oder 2, dadurch gekennzeichnet, daß es des weiteren folgendes umfaßt:
Aktivierungsmittel (40), das mit dem Verhinderungsmittel (T11) verbunden ist, welches auf ein erstes Signal (RWL1, RWL2) anspricht, um das Verstärkungsmittel (42, C_{B}) zu aktivieren, und das mit dem Erkennungsmittel (38) verbunden ist, wobei das Erkennungsmittel mit einem zweiten Signal (TMA) verbunden ist, um das Erkennungsmittel (38) während des Testmodus zu aktivieren.

4. Signalspielraumprüfsystem nach Anspruch 2 oder 3, dadurch gekennzeichnet, daß das Erkennungsmittel (38) auf das zweite Signal (TMA) anspricht, um das Verstärkungsmittel (42, C_{B}) während des Testmodus funktionsunfähig zu machen, wobei eine zweite Spannung mit einer geringeren Größe als die vorgesehene Größe an die Wortleitung (WL1) gelegt wird.

5. Signalspielraumprüfsystem wie in Anspruch 4 dargelegt, dadurch gekennzeichnet, daß die Größe der zweiten Spannung in negativer Hinsicht geringer ist als die der ersten Spannung.

6. Signalspielraumprüfsystem wie in Anspruch 6 dargelegt, dadurch gekennzeichnet, daß die erste Spannung eine Größe von -0,5 Volt hat und die zweite Spannung eine Größe von Null Volt hat.

7. Signalspielraumprüfsystem nach jedem der obigen Ansprüche, dadurch gekennzeichnet, daß das Verstärkungsmittel (42, C_{B}) einen Kondensator (C_{B}) enthält.

8. Signalspielraumprüfsystem nach jedem der obigen Ansprüche 3 bis 7, dadurch gekennzeichnet, daß das Aktivierungsmittel (40) erste (DWLB) und zweite (RWL1, RWL2) Eingänge und einen Ausgang hat, wobei der Ausgang mit der Spannungsverstärkungsschaltung (42) und der erste Eingang mit einem Ausgang des Erkennungsmittels (38) verbunden ist.

9. Signalspielraumprüfsystem nach jedem der obigen Ansprüche, dadurch gekennzeichnet, daß das Speichersystem (22) des weiteren eine Referenzwortleitung (RWL1) enthält.

10. Signalspielraumprüfsystem nach Anspruch 9, dadurch gekennzeichnet, daß der zweite Eingang des Aktivierungsmittels (40) mit der Referenzwortleitung (RWL1) verbunden ist.

11. Signalspielraumprüfsystem nach jedem der obigen Ansprüche 2 bis 10, dadurch gekennzeichnet, daß es des weiteren folgendes umfaßt:
einen mit der Wortleitung (WL1) verbundenen Treiber (20), wodurch das Verhinderungsmittel (T11) mit dem Treiber (20) verbunden ist.

12. Signalspielraumprüfsystem nach jedem der obigen Ansprüche 3 bis 11, dadurch gekennzeichnet, daß das erste Signal (RWL1, RWL2) von der Wortleitung (WL1) abgeleitet wird und das zweite Signal ein Adreßsignal (TMA) ist.

13. Signalspielraumprüfsystem nach jedem der obigen Ansprüche 3 bis 12, dadurch gekennzeichnet, daß das Aktivierungsmittel (40) eine Wortleitungs-Erkennungsschaltung (40) umfaßt.

14. Signalspielraumprüfsystem nach jedem der obigen Ansprüche 3 bis 13, dadurch gekennzeichnet, daß das erste Signal von der Referenzwortleitung (RWL1, RWL2) abgeleitet wird.

15. Signalspielraumprüfsystem nach jedem der obigen Ansprüche, dadurch gekennzeichnet, daß es des weiteren folgendes umfaßt:
eine Vielzahl von Bitleitungen (BL1, BL2) und
eine Leseverstärkerschaltung (34) mit Eingängen, die mit der Vielzahl der Ditleitungen (BL1, BL2) verbunden sind;
wobei jede Speicherzelle (24, 26) mit einer der Vielzahl der Eitleitungen (BL1, BL2) verbunden ist.

16. Signalspielraumprüfsystem nach Anspruch 15, dadurch gekennzeichnet, daß es des weiteren folgendes umfaßt:
eine Spannungsreferenzzelle (30), die mit der Referenzwortleitung (RWL2) und mit einer ersten (BL2) der Vielzahl der Bitleitungen (BL1, BL2) verbunden ist.

17. Signalspielraumprüfsystem nach jedem der obigen Ansprüche, dadurch gekennzeichnet, daß es des weiteren folgendes umfaßt:
Anschlußmittel, um eine Vielzahl von Adressen zu empfangen,
Wortdecodiermittel (16), das erste und zweite Ausgänge hat, und
Mittel (12, 14), um eine erste der Vielzahl von Adressen an einen Eingang des Wortdecodiermittels (16) zu legen.

18. Signalspielraumprufsystem nach Anspruch 17, dadurch gekennzeichnet, daß
der Treiber (20) einen Eingang und einen Ausgang hat, wobei der Eingang mit dem ersten Ausgang des Wortdecodiermittels (16) verbunden ist,
das Erkennungsmittel (38) eine zweite der Vielzahl von Adressen empfängt,
das Aktivierungsmittel (40) mit dem zweiten Ausgang des Wortdecodiermittels (16) und mit dem Ausgang des Erkennungsmittels (38) verbunden ist,
ein Wortleitungs-Pulldown-Knoten (WLPD) mit dem Ausgang des Treibers (20) verbunden ist,
das Verhinderungsmittel (T11) eine Steuerelektrode hat, die zwischen dem Wortleitungs-Pulldown-Knoten (WLPD) und einem Punkt des Referenzpotentials angeordnet ist, wobei die Steuerelektrode mit dem Ausgang des Aktivierungsmittels (40) verbunden ist,
der Kondensator (C_{B}) erste und zweite Elektroden hat, wobei die erste Elektrode mit dem Wortleitungs-Pulldown-Knoten verbunden ist, und
die Spannungsverstärkungsschaltunq (42) einen mit dem Ausgang des Aktivierungsmittels (40) verbundenen Eingang und einen mit der zweiten Elektrode des Kondensators (C_{B}) verbundenen Ausgang hat.

19. Signalspielraumprüfsystem nach jedem der obigen Ansprüche, dadurch gekennzeichnet, daß das Verstärkungsmittel (42, C_{B}) eine Pufferschaltung (42) umfaßt, die erste (11) und zweite (I2) Inverter enthält, wobei jeder der Inverter einen P-Kanal-Feldeffekttransistor (T12, T14) enthält, der mit einem N-Kanal-Feldeffekttransistor (T13, T15) in Reihe geschaltet ist.

20. Signalspielraumprüfsystem nach jedem der obigen Ansprüche, dadurch gekennzeichnet, daß das Erkennungsmittel (38) eine Testmodus-Decodierschaltung (38) enthält, die auf Adreßsignale (TMA) anspricht.

21. Signalspielraumprüfsystem nach jedem der obigen Ansprüche, dadurch gekennzeichnet, daß das Verhinderungsmittel (T11) ein N-Kanal-Feldeffekttransistor ist.

## Revendications

1. Système de test de marge de signal, pour effectuer une séquence de test dans un système à mémoire (22), dans lequel on accède à des cellules de mémoire (24, 26) sélectionnées pour effectuer une lecture ou une écriture pendant un cycle d'accès, chacune des cellules-mémoire comprenant un dispositif de transfert (T3, T4) ayant une électrode de commande recevant un signal d'accès, une première électrode commandée, couplée à une ligne de sortie, et une deuxième électrode commandée, et des moyens de stockage (C1, C2) couplés à la deuxième électrode commandée du dispositif de transfert (T3, T4), le système comprenant :
des moyens d'amplification (42, C_{B}), pour amplifier le signal d'accès au moins une fois durant le cycle d'accès, et
des moyens de détection (38) pour détecter que le système à mémoire est en mode de test;
caractérisé par
des moyens d'empêchement (T11), réagissant aux moyens de détection (38) pour empêcher les moyens d'amplification (42, C_{B}) de fonctionner pendant au moins la durée totale d'un cycle d'accès pendant le mode de test.

2. Système de test de marge de signal selon la revendication 1, caractérisé en ce que
le système à mémoire (22) comprend une ligne de mot (WL1), et
les moyens d'amplification (42, C_{B}) comprend un circuit d'amplification de tension (42), destiné à appliquer une première tension d'amplitude donnée à la ligne de mot (WL1).

3. Système de test de marge de signal selon la revendication 1 ou 2, caractérisé par le fait de comprendre en outre
un moyen d'activation (40), couplé au moyen d'empêchement (T11) réagissant à un premier signal (RWL1, RWL2) pour activer les moyens d'amplification (42, C_{B}) et couplé auxdits moyens de détection (38), lesdits moyens de détection étant couplés à un deuxième signal (TMA) pour activer les moyens de détection (38) durant le mode de test.

4. Système de test de marge de signal selon la revendication 2 ou 3, caractérisé en ce que les moyens de détection (38) réagissent au deuxième signal (TMA) pour rendre inactif les moyens d'amplification (42, C_{B}) pendant le mode de test, dans lequel une deuxième tension d'une valeur inférieure à la valeur donnée est appliquée à la ligne de mot (WL1).

5. Système de test de marge de signal selon la revendication 4, caractérisé en ce que la valeur de la deuxième tension est inférieure à celle de la première tension, dans un sens négatif.

6. Système de test de marge de signal selon la revendication 5, caractérisé en ce que la première tension a une valeur de 0,5 Volts et la deuxième tension a une valeur de 0 Volt.

7. Système de test de marge de signal selon l'une quelconque des revendications précédentes, caractérisé en ce que les moyens d'amplification (42, C_{B}) comprennent un condensateur (C_{B}).

8. Système de test de marge de signal selon l'une quelconque des revendications 3 à 7, caractérisé en ce que le moyen d'activation (40) a des premières (DWLB) et des deuxièmes (RWL1, RWL2) entrées et une sortie, la sortie étant couplée au circuit d'amplification de tension (42) et la première entrée étant reliée à une sortie des moyens de détection (38).

9. Système de test de marge de signal selon l'une quelconque des revendications précédentes, caractérisé en ce que le système à mémoire (22) comprend en outre une ligne de mot de référence (RWL1).

10. Système de test de marge de signal selon la revendication 9, caractérisé en ce que la deuxième entrée du moyen d'activation (40) est reliée à la ligne de mot de référence (RWL1).

11. Système de test de marge de signal selon l'une quelconque des revendications précédentes 2 à 10, caractérisé par le fait de comprendre en outre un coupleur d'attaque (20), relié à la ligne de mot (WL1), de manière que le moyen d'empêchement (T11) soit couplé au coupleur d'attaque (20).

12. Système de test de marge de signal selon l'une quelconque des revendications 3 à 11 précédentes, caractérisé en ce que le premier signal (RWL1, RWL2) est dérivé de la ligne de mot (WL1) et le deuxième signal est un signal d'adresse (TMA).

13. Système de test de marge de signal selon l'une quelconque des revendications 3 à 12 précédentes, caractérisé en ce que le moyen d'activation (40) comprend un circuit de détection de ligne de mot (40).

14. Système de test de marge de signal selon l'une quelconque des revendications 3 à 13 précédentes, caractérisé en ce que le premier signal est dérivé de la ligne de mot de référence (RWL1, RWL2).

15. Système de test de marge de signal selon l'une quelconque des revendications précédentes, caractérisé par le fait de comprendre en outre :
une pluralité de lignes de binaires (BL1, B12), et
un circuit amplificateur de détection (34) ayant des entrées reliées à la pluralité de lignes de binaires (BL1, B12);
dans lequel chaque cellule-mémoire (24, 26) est reliée à l'une parmi la pluralité des lignes de binaires (BL1, B12).

16. Système de test de marge de signal selon les revendications 15, caractérisé par le fait de comprendre en outre
une cellule de référence de tension (30) reliée à la ligne de mot de référence (RWL2) et à une première (BL2) parmi la pluralité des lignes de binaires (BL1, B12) .

17. Système de test de marge de signal selon l'une quelconque des revendications précédentes, caractérisé par le fait de comprendre en outre
des moyens de lecture-écriture, pour recevoir une pluralité d'adresses,
des moyens de décodage de mots (16) ayant des première et deuxième sorties, et
des moyens (12, 14) pour appliquer une première parmi la pluralité d'adresses à une entrée des moyens de décodage de mots (16).

18. Système de test de marge de signal selon la revendication 17, caractérisé en ce que
le coupleur d'attaque (20) a une entrée et une sortie, l'entrée étant couplée à la première sortie des moyens de décodage de mots (16),
les moyens de détection (38) reçoivent une deuxième parmi la pluralité d'adresses,
le moyen d'activation (40) est couplé à la deuxième sortie des moyens de décodage de mots (16) et à la sortie des moyens de détection (38),
un noeud d'abaissement de ligne de mot (WLPD) est couplé à la sortie du coupleur d'attaque (20),
le moyen d'empêchement (T11) ayant une électrode de commande disposée entre le noeud d'abaissement de ligne de mot (WLPD) et un point à potentiel de référence, l'électrode de commande étant couplée à la sortie du moyen d'activation (40),
le condensateur (C_{B}) ayant des première et deuxième plaques, la première plaque étant couplée au noeud d'abaissement de ligne de mot, et
le circuit d'amplification de tension (42) ayant une entrée couplée à la sortie du moyen d'activation (40) et une sortie couplée à la seconde plaque du condensateur (C_{B}).

19. Système de test de marge de signal selon l'une quelconque des revendications précédentes, caractérisé en ce que les moyens d'amplification (42, C_{B}) comprennent un circuit tampon (42) comprenant des premiers (I1) et des deuxièmes (I2) inverseurs, chacun des inverseurs comprenant un transistor à effet de champ à canal P (T12, T14) branché en série avec un transistor à effet de champ à canal N (T13, T15).

20. Système de test de marge de signal selon l'une quelconque des revendications ci-dessus, caractérisé en ce que les moyens de détection (38) comprennent un circuit de décodage de mode de test (30) réagissant aux signaux d'adresses (TMA).

21. Système de test de marge de signal selon l'une quelconque des revendications précédentes, caractérisé en ce que le moyen d'empêchement (T11) est un transistor à effet de champ à canal N.
